(19) Europäisches Patentamt / European Patent Office / Office européen des brevets

(11) **EP 2 420 876 B1**

(12) **EUROPEAN PATENT SPECIFICATION**

(45) Date of publication and mention
of the grant of the patent:
**29.06.2016 Bulletin 2016/26**

(21) Application number: **10737460.5**

(22) Date of filing: **26.02.2010**

(51) Int Cl.:
*C03B 37/012* (2006.01)    *C03B 37/014* (2006.01)
*G02B 6/02* (2006.01)    *G02B 6/028* (2006.01)
*C03B 37/018* (2006.01)    *G02B 6/036* (2006.01)

(86) International application number:
**PCT/CN2010/070766**

(87) International publication number:
**WO 2010/148661 (29.12.2010 Gazette 2010/52)**

(54) **SINGLE-MODE OPTICAL FIBER AND MANUFACTURE METHOD THEREOF**

EINMODENFASER UND HERSTELLUNGSVERFAHREN DAFÜR

FIBRE OPTIQUE MONOMODE ET SON PROCÉDÉ DE FABRICATION

(84) Designated Contracting States:
**AT BE BG CH CY CZ DE DK EE ES FI FR GB GR
HR HU IE IS IT LI LT LU LV MC MK MT NL NO PL
PT RO SE SI SK SM TR**

(30) Priority: **26.06.2009 CN 200910062855**

(43) Date of publication of application:
**22.02.2012 Bulletin 2012/08**

(73) Proprietor: **Yangtze Optical Fibre and Cable
Company, Ltd.
Wuhan Hubei 430073 (CN)**

(72) Inventors:
• **HAN, Qingrong
Wuhan,
Hubei 430073 (CN)**
• **YANG, Chen
Wuhan,
Hubei 430073 (CN)**
• **LI, Jing
Wuhan,
Hubei 430073 (CN)**

• **LUO, Jie
Wuhan,
Hubei 430073 (CN)**

(74) Representative: **Zeuner, Stefan
Zeuner Summerer Stütz
Nußbaumstrasse 8
80336 München (DE)**

(56) References cited:
**EP-A1- 1 785 754      EP-A1- 1 788 411
EP-A1- 1 806 599      CN-A- 1 186 248
CN-A- 1 403 397      CN-A- 1 448 743
CN-A- 1 971 321      CN-A- 101 414 028
CN-A- 101 598 834      US-A- 4 852 968
US-A1- 2005 000 253**

• **MATSUO S ET AL: "LOW-BENDING-LOSS AND
LOW-SPLICE-LOSS SINGLE-MODE FIBERS
EMPLOYING A TRENCH INDEX PROFILE", IEICE
TRANSACTIONS ON ELECTRONICS, INSTITUTE
OF ELECTRONICS, TOKYO, JP, vol. E88-C, no. 5,
1 May 2005 (2005-05-01) , - 31 May 2005
(2005-05-31), pages 889-895, XP001231156, ISSN:
0916-8524, DOI: 10.1093/IETELE/E88-C.5.889**

**Description**

FIELD OF THE INVENTION

The invention relates to the field of optical communication technology, and more particularly to a single mode fiber suitable for access network or long wavelength and a manufacturing method thereof. The fiber has excellent bending resistance and moderate effective area.

BACKGROUND OF THE INVENTION

In recent years, Fiber-to-the-home and Fiber-to-the-curb (FTTx) has become a hot topic in the construction of fiber network and fibers suitable for FTTx have been in-depthly studied. As single mode fibers are popularly used in the access network and low water peak fibers are widely used, low water peak fibers with bending insensitivity have gradually attracted people's attention. Conventional low water peak mode fibers (in accordance with ITU-TG652C/D) have a bending radius of 30 mm, so the cabling thereof in indoor and narrow environment is greatly restricted. In comparison with the application of long-distance transmission, fibers endure a high bending stress, especially a long fiber is wrapped in a small storage box when it is used, thereby enduring great bending stress. To meet the requirements of the FTTx network construction and apparatus miniaturization, fibers with bending insensitivity are desired. Moreover, in Dec. 2006, ITU-T announced a new fiber standard (G657 fibers): "Characteristics of a bending loss insensitive single mode optical fiber and cable for the access network". Thus, to develop a bending resistant single mode fiber is of immense significance for promoting the development of optical fiber access technology.

After years of research, it is well-known that the macro-bend loss of fibers is mainly related to the mode field diameter and cutoff wavelength of the fiber. Bending properties of fibers can be measured by an MAC value, which is defined as a ratio of mode field diameter to cutoff wavelength at 1,550 nm wavelength. The smaller the MAC value, the better the bending properties of fibers. Obviously, to reduce the mode field diameter or increase the cutoff wavelength can decrease the MAC value, which is achieved by slightly modifying the parameters of current matched-cladding single mode fibers (as shown in FIG. 1). U.S. Pat. No.2007/0077016A1, Chinese Patent No.1971321A, and Chinese Patent No.1942793A disclose the method. However, if the mode field diameter is too small, the splicing loss will be large when connecting to conventional single mode fibers and the launching power is limited. Meanwhile, considering the characteristics of multi-services of FTTx, in order to transmit with the whole band, the cutoff wavelength of fibers should less than or equal to 1,260 nm. Thus, the increase of the cutoff wavelength of the fibers is very limited. Furthermore, improving doping increases numerical aperture (NA), but high doping causes the increase of attenuation. Therefore, the method has certain limitations.

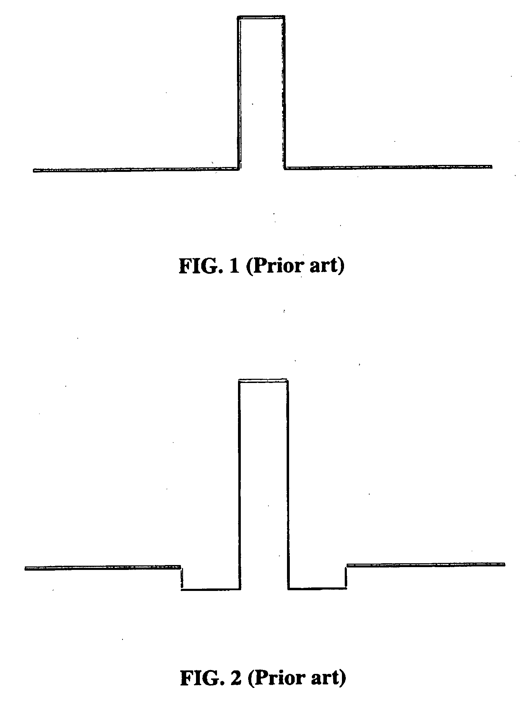

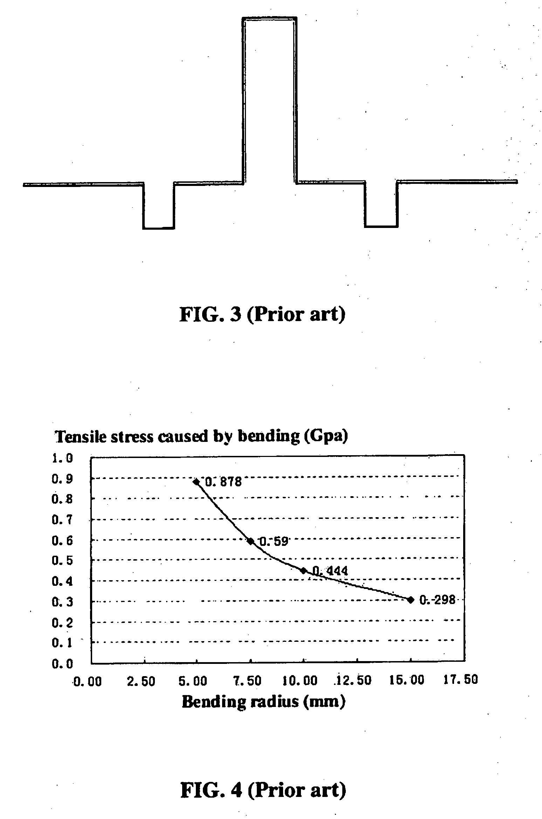

Another effective method to improve bending properties of fibers is to design a depressed cladding (as shown in FIG 2), as disclosed in U.S. Pat. No. 5,032,001, U.S. Pat. No.7043125B2, and Chinese Patent No.1766680A. The design increases the numerical aperture (NA) of fibers without increasing the dopant in the cores of fibers, thereby avoiding the increase of attenuation caused by doping. The most effective method to improve the bending resistance of fibers is to design a depressed outer cladding (as shown in FIG 3), whose basic waveguide structure is disclosed in U.S. Pat. No. 4852968, U.S. Pat. No. 6535679B2, and Chinese Patent No.1982928A. However, the above-mentioned patents only aim at reducing additional bending loss, not considering the long-term service life of fibers under small bending radius. Moreover, in fiber links, particularly in FTTx links, due to multi-point bending and connectors, multi-path interference (MPI) appears. The measurement of MPI was disclosed by David Z.hen in 2009 at OFC/NFOEC ("Testing MPI Threshold in Bend Insensitive Fiber Using Coherent Peak-To-Peak Power Method"). In the design of the depressed outer cladding, the depressed cladding should be located accurately, if too close to the core, once the core deviates at the fiber connection point, the MPI easily occurs; if too far from the core, the additional bending loss cannot be decreased.

Document EP 1 806 599 A1 discloses an optical fiber comprising a center core and a cladding located at an outer periphery of the core, wherein the core comprises at least one codoped layer made from silica glass doped with germanium and fluorine, and at least one lower-concentration codoped layer made from silica glass doped with germanium, or silica glass that is doped with germanium and fluorine wherein a dope amount of the fluorine is smaller than a dope amount of the fluorine in the codoped layer.

When a fiber bends, the outside thereof is exposed to the tensile stress. The tensile stress is represented by the following formula:

$$\sigma = \frac{E \cdot r}{(R + C_{th} + r)} \qquad (1)$$

wherein E represents young modulus of silica glass, R represents a bending radius, r represents the radius of a fiber, and $C_{th}$ represents the thickness of a coating. Based on the formula (1), the tensile stress imposed on a fiber with a glass cladding diameter of 125 $\mu$m and an outer diameter of 250 $\mu$m is calculated when the fiber has different bending radius, as shown in FIG 4. As shown in FIG 4, when the bending radius is decreased to 6.5 mm, the tensile stress imposed on the outer bending wall of the fiber is 0.69 GPa (100 kpsi), which reaches the common screening tension of fibers. Fiber fracture caused by bending occurs in the process of fiber-laying, thereby increasing the laying cost. More seriously, the fiber will fracture in using process because the micro-crack will expand when the tensile stress imposed on the fiber, thereby increasing maintenance cost and affecting the reliability of systems in the application of FTTx. Upon preparing a fiber or a preform, to achieve an expected refractive index profile, when refractive index changes, the material compositions vary accordingly, so that physical properties thereof are different, thereby different layers have different thermal expansion coefficient, heat capacity, and glass transition temperature. In the process of fiber drawing, because of different heating and cooling rate, the residual stress is inevitably produced. During the process of drawing, the stress originated from different glass transition temperature is equivalent to mechanical stress, which is temporary stress and directly proportional to the drawing stress, and can be removed by adjusting the fiber drawing process, for example, adding a holding furnace to a drawing tower and properly controlling the drawing rate to anneal. However, the stress originated from different thermal expansion coefficient is permanent stress, which is hardly removed by adjusting the fiber drawing process, but must be removed by designing material composition and structure. The appendix of fiber standard ITU-TG657 briefly describes the prediction of fiber life. The service life of fibers is related to the anti-fatigue index thereof. Under identical bending radius and storage length, the higher the anti-fatigue index of fibers, the higher the mechanical reliability thereof. Thus, to meet the requirements of the access network, a need has arisen for providing an all-solid transmission fiber that meets the standards G652 and G657 and has low additional bending loss, stable mechanical properties, and uniform material composition.

## SUMMARY OF THE INVENTION

To expediently describe the invention, partial technical terms involved are defined below:

"Mandrel" refers to a preform comprising a core and some claddings coated thereon.

"Refractive index profile" refers to the relation between the glass refractive index of a fiber or a preform (such as mandrel) and the radius thereof.

"Relative refractive index difference" is defined by the following formula:

$$\Delta\% = \left[ \left( n_i^2 - n_0^2 \right) \middle/ 2n_i^2 \right] \times 100\% \approx \frac{n_i - n_0}{n_0} \times 100\%$$

wherein $n_i$ and $n_0$ represent the glass refractive index of a material and pure silica respectively.

"The contribution of fluorine" refers to the relative refractive index difference ($\Delta_F$) between a fluorine-doped silica glass and a pure silica glass, representing the amount of doped fluorine.

"The contribution of germanium" refers to the relative refractive index difference ($\Delta_{Ge}$) between a germanium-doped silica glass and a pure silica glass, representing the amount of doped germanium.

"Casing tube" refers to a pure silica glass tube with a certain geometry and cross-sectional area.

"RIT process" refers to inserting a mandrel into a casing tube to form a fiber preform.

"OVD outer cladding deposition process" refers to coating $SiO_2$ glass on a mandrel to a desired thickness using external vapor deposition and sintering processes.

"VAD outer cladding deposition process" refers to coating $SiO_2$ glass on a mandrel to a desired thickness using axial vapor deposition and sintering processes.

"APVD outer cladding process" refers to coating $SiO_2$ glass on a mandrel to a desired thickness by melting natural or synthetic quartz powder with high frequency plasma flame.

"O/Si ratio" refers to the molar ratio of oxygen to silicon tetrachloride added into reaction zone in the process of PCVD.

In view of the above-described problems, the objects of the present invention is to provide a single mode fiber having rational material composition and structure, high mechanical reliability, long service life, and good bending resistance, as well as to provide a manufacturing method thereof.

To achieve the above objects, the present invention provides a single mode fiber, and the single mode fiber comprises a core, an inner cladding, a depressed cladding and an outer cladding composed of pure silica glass, wherein the core is surrounded in sequence with the inner cladding and the depressed cladding; the core comprises silica glass doped with germanium and fluorine, with a diameter (a) of 8.0-8.8 $\mu$m, a relative refractive index difference ($\Delta_1$) of 0.35-0.38%, and the contribution of fluorine ($\Delta_F$) is -0.09 $\pm$ 0.02%; the inner cladding comprises silica glass doped with germanium and fluorine, with a diameter (b) of 18-21 $\mu$m and a relative refractive index difference ($\Delta_2$) of 0 $\pm$ 0.02%;

the depressed cladding comprises silica glass doped with fluorine, with a diameter (c) of 26-36 $\mu$m and a relative refractive index difference ($\Delta_{32}$) at the external interface thereof (32) (a depositing start point of the depressed outer cladding) is between -0.22 and -0.35%, and a relative refractive index difference ($\Delta_{31}$) at the internal interface thereof (31) (a depositing end point of the depressed outer cladding) is between -0.20 and -0.35%, and $\Delta_{32} \leq \Delta_{31}$.

In a class of this embodiment, the material composition of the silica glass doped with germanium and fluorine is $SiO_2$-$GeO_2$-F-Cl, and the material composition of the silica glass doped with fluorine is $SiO_2$-F-Cl.

In a class of this embodiment, the introduced chlorine originates from the reaction between silicon tetrachloride ($SiCl_4$) and/or germanium tetrachloride ($GeCl_4$) and oxygen. The fluctuation of chlorine content has little influence on the properties of the fiber. Moreover, the chlorine content has little fluctuation under stable process conditions. Thus, there is no specific control and requirement on the chlorine content.

In a class of this embodiment, in the inner cladding, the amount of doped fluorine and germanium is on the increase gradually from the outer interface to the inner interface, exhibiting a gradient change; the contribution of fluorine of the outer interface of the inner cladding is -0.10 $\pm$ 0.01 %; the contribution of fluorine of the inner interface of the inner cladding is -0.16 $\pm$ 0.01%.

In a class of this embodiment, the contribution of fluorine of the outer interface of the inner cladding (31) (a depositing start point of the inner cladding) is -0.10 $\pm$ 0.01%; the contribution of fluorine of the inner interface of the inner cladding (21) (a depositing end point of the inner cladding) is -0.16 $\pm$ 0.01%.

In a class of this embodiment, the outer cladding has a diameter (d) of 78-126 $\mu$m.

In a class of this embodiment, a mode field diameter of the fiber at the wavelength of 1310 nm is 8.5-9.3 $\mu$m; a zero dispersion wavelength thereof is 1302-1322 nm; a dispersion slope thereof at the zero dispersion wavelength is less than or equal to 0.090 ps/nm$^2$·km.

In a class of this embodiment, an attenuation coefficient of the fiber at the wavelength of 1310 nm is less than or equal to 0.344 dB/km, an attenuation coefficient of the fiber at the wavelength of 1383 nm (hydrogen has been aged) is less than or equal to 0.334 dB/km, an attenuation coefficient of the fiber at the wavelength of 1550 nm is less than or equal to 0.214 dB/km, an attenuation coefficient of the fiber at the wavelength of 1625 nm is less than or equal to 0.224 dB/km, and an attenuation coefficient of the fiber at the wavelength of 1675 nm is less than or equal to 0.284 dB/km.

In a class of this embodiment, a cutoff wavelength of the fiber is less than or equal to 1260 nm; at the wavelength of 1625 nm, an additional bending loss of the fiber after surrounding a 10 mm bending radius once is less than or equal to 0.2 dB, or even less than or equal to 0.1 dB; an additional bending loss of the fiber after surrounding a 7.5 mm bending radius once is less than or equal to 0.5 dB or even less than or equal to 0.2 dB; an additional bending loss of the fiber after surrounding a 5 mm bending radius once is less than or equal to 1.0 dB or even less than or equal to 0.5 dB.

A method for manufacturing the single mode fiber of the present invention comprises the steps of: fixing a pure silica glass liner tube on a plasma enhanced chemical vapor deposition (PCVD) lathe for doping and depositing; adding a fluorine-containing gas into the reactive gases of silicon tetrachloride and oxygen to introduce fluorine doping and adding germanium tetrachloride into the reactive gases of silicon tetrachloride and oxygen to introduce germanium doping; ionizing the reactive gas in the liner tube with microwave into plasma and depositing the plasma in the form of glass on the inner wall of the liner tube; altering the flow of the doped gas in the mixed gas according to the doping requirements of optical waveguide structure and depositing a depressed cladding, an inner cladding, and a core in sequence; ,melting the depositing tube into a solid mandrel with an electric heating furnace after depositing; preparing a fiber preform using RIT process with synthetic silica glass as a casing tube, or by depositing an outer cladding surrounding the solid mandrel using OVD, VAD, or APVD outer depositing process; drawing the fiber preform placed on a fiber drawing tower and coating two layers of UV-cured acrylic resin polymer on the surface of the fiber.

In a class of this embodiment, the fluorine-containing gas is $C_2F_6$, $CF_4$, $SiF_4$, $C_4F_8$, $SF_6$, or a mixture thereof.

In a class of this embodiment, in the process of depositing the depressed cladding, the furnace temperature is controlled at 1,080-1,120°C, the O/Si ratio is 3.0-3.5, and the chlorine content is less than 2,500 ppm.

In a class of this embodiment, in the process of depositing the inner cladding and the core, the furnace temperature is controlled at 1,000-1,050°C, the O/Si ratio is 2.2-2.6, and the chlorine content is 3,500-4,200 ppm.

The doped chlorine has little influence on Rayleigh scattering of silica glass, but increases the refractive index and lowers the viscosity thereof. Thus, high content of chlorine is contained in the inner cladding and the core of the fiber so as to decrease the mount of germanium doping to reduce the attenuation coefficient of the fiber. It is noted that the chlorine content cannot be too high, or bubbles easily occur. In the depressed outer cladding, the content of chlorine is desired to be decreased so as to decrease the amount of the doped fluorine to prevent the viscosity from being too low. For PCVD process, the chlorine content is determined by the furnace temperature and the O/Si ratio of the reactive gas, and decreases with the increase of the furnace temperature and O/Si ratio.

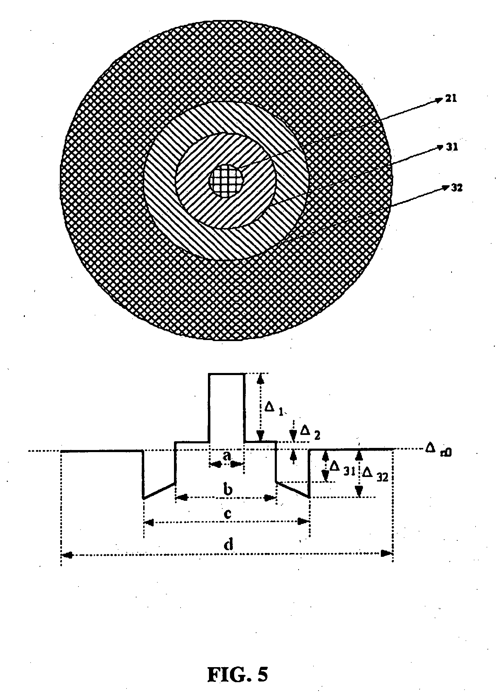

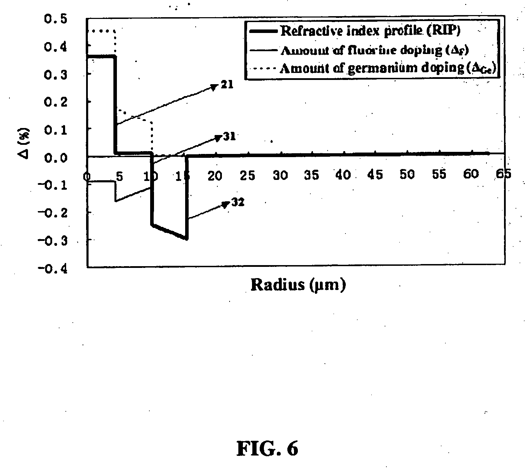

Advantages of the invention are summarized below: 1.a fiber having a functionally graded material composition and structure (as shown in FIG 5) is provided, the fiber comprises the core, the functionally graded inner cladding, the depressed cladding, and the outer cladding; the depressed cladding is fluorine-doped silica glass, with the lowest refractive index and the lowest modulus, which improves the bending resistance, buffers the tensile stress of the fiber surface resultant from high coefficient of thermal expansion of the germanium-doped core ,which affects the mechanical properties of the fiber and forms pressure stress in the fiber core, prevents the additional stress generated by fiber bending from passing on to the core for avoiding the increase of attenuation, and effectively improves the mechanical properties and service life of the fiber; 2. the core and the inner cladding are fluorine-doped and germanium-doped silica glass such that the fiber possesses the optical properties of G652.D fibers; the interface viscosity of the core and the inner cladding are similar, which avoids generating defects on the interface of the core/cladding in the process of fiber drawing; and in the inner cladding, the amount of doped fluorine and germanium is on the increase gradually from the outer interface to the inner interface, exhibiting a gradient change (as shown in FIG 6), which means the coefficient of expansion is on the increase gradually, thereby preventing the generation of residual stress in the process of fiber drawing, and further improving the mechanical properties of the fiber; 3 the fiber of the invention meets the standards G657.A/B and G652.D, in comparison with conventional G652 fibers, the fiber exhibits better compatibility, meets the requirements of network layout and apparatus miniaturization, and meanwhile can be used in long wavelength (1625-1675 nm).

## BRIEF DESCRIPTION OF THE DRAWINGS

FIG **1** is a schematic diagram of a refractive index profile of a matched-cladding fiber;

FIG **2** is a schematic diagram of a refractive index profile of a depressed cladding fiber;

FIG **3** is a schematic diagram of a refractive index profile of a depressed outer cladding fiber;

FIG **4** is a graph illustrating the relationship between a bending radius of a fiber and the tensile stress caused by the fiber bending;

FIG **5** is a schematic diagram of a section and a refractive index profile of a fiber;

FIG **6** is a schematic diagram of a refractive index profile and a doping profile of a fiber according to one embodiment of the invention.

## DETAILED DESCRIPTION OF THE EMBODIMENTS

Detailed embodiments for further illustrating the invention are described below.

Fluorine and germanium decrease the viscosities of fluorine-doped silica glass and germanium-doped silica glass, but the effect is different. Upon producing the identical refractive index difference by introduction of fluorine and germanium, the effect of fluorine on viscosity is thrice that of germanium. Studies (Qingrong Han et al., "Material Composition and Structure Design in PCVD Silica-based Single-Mode fiber", Proc. Of SPIE Vol. 6352 635236-1- 8, for reference) show that, to make the viscosity of the core or the viscosity of the cladding match, the following formula should be satisfied:

$$\Delta_{F2} = \Delta_{F1} - 0.205 * \Delta_{Total}$$

wherein $\Delta F_1$ and $\Delta F_2$ represent the contribution of fluorine of the core and the inner cladding respectively; $\Delta_{Total}$ represents the relative refractive index difference of the core relative to the inner cladding.

For the coefficients of thermal expansion of fluorine-doped silica glass and germanium-doped silica glass, doped fluorine decreases the coefficient of thermal expansion of fluorine-doped silica glass, and germanium increases the coefficient of thermal expansion of germanium-doped silica glass. The coefficient of thermal expansion $\alpha_{SiO2-GeO2-F}$ (/°C) is calculated by the formula: $\alpha_{SiO2-GeO2-F} = (5 + 8.3\Delta_{Ge} + 2.3_{\Delta F}) \times 10^{-7}$.

A depressed outer cladding is designed and the amount of doped fluorine is calculated according to the above-mentioned results. After the mount of doped fluorine is determined, the amount of doped germanium of each cladding is calculated according to the refractive index profile. Following the method of the invention, a preform with a diameter of 80 mm is prepared, with two layers of coatings of a single mode fiber and a drawing speed of 1,300 m/min. The structure and material composition of the fiber are shown in Table 1.

The additional macro-bend loss is tested following the method taught by IEC 60793-1-47. The longer the wavelength, the more sensitive to bending. Thus, the test is carried out mainly at the wavelength of 1625 nm to assess the bending sensitiveness of the fiber in the range of the whole wavelength (particularly L band). The fiber is coiled into one or ten circles with a diameter, and then the change of the optical power before and after coiling is tested after the circles are loosened. The change is considered as the additional macro-bend loss of the fiber. To assess the mechanical properties of the fiber accurately, the intensity distribution thereof must be tested with a reliable method. The fibers with big crack are screened by a screening test and those passing the test are further analyzed and tested to find and assess the reliability of the fiber. Following IEC60793-1-33, the anti-fatigue parameter $n_d$ of the fiber is determined using two point bending test. The method is close to the actual application, and the results are beneficial to analyze and judge the bending radius of the fiber. The main performance parameters of the fiber are shown in Table **2.** In examples of Table **1,** the difference of Example **9** or **10** in contrast to Example **8** is that the former comprises an inner cladding without a functionally graded material composition and structure. Tests show that, with a functionally graded material composition and structure, the attenuation coefficient of the fiber decreases, and the anti-fatigue parameters thereof are increased.

**Claims**

1. A single mode fiber, comprising:

   a core,
   an inner cladding,
   a depressed cladding, and
   an outer cladding composed of pure silica glass,
   wherein

   said core is surrounded in sequence with said inner cladding and said depressed cladding;

   **characterized in that**

   said core comprises silica glass doped with germanium and fluorine, with a diameter of 8.0-8.8 $\mu$m, a relative refractive index difference $\Delta_1$ of 0.35-0.38%, and the contribution of fluorine $\Delta_F$ is -0.09 $\pm$ 0.02%; said inner cladding comprises silica glass doped with germanium and fluorine, with a diameter of 18-21 $\mu$m and a relative refractive index difference $\Delta_2$ of 0 $\pm$ 0.02%; and said depressed cladding comprises silica glass doped with fluorine, with a diameter of 26-36 $\mu$m and a relative refractive index difference $\Delta_{32}$ at the external interface thereof is between -0.22 and -0.35%, and a relative refractive index difference $\Delta_{31}$ at the internal interface thereof is between -0.20 and -0.35%, and $\Delta_{32} \leq \Delta_{31}$.

2. The a single mode fiber as claimed in claim 1, wherein in said inner cladding, the amount of doped fluorine and doped germanium is on the increase gradually from said outer interface to said inner interface, exhibiting a gradient change; the contribution of fluorine $\Delta_F$ of the outer interface of said inner cladding is -0.10 $\pm$ 0.01%; the contribution of fluorine $\Delta_F$ of the inner interface of said inner cladding is -0.16 $\pm$ 0.01%.

3. The single mode fiber as claimed in claim 1 or claim 2, wherein the material composition of the silica glass doped with germanium and fluorine is $SiO_2$-$GeO_2$-F-Cl, and the material composition of the silica glass doped with fluorine is $SiO_2$-F-Cl.

4. The single mode fiber as claimed in claim 1 or claim 2, wherein said outer cladding has a diameter of 78-126 $\mu$m.

5. The single mode fiber as claimed in claim 1 or claim 2, wherein a mode field diameter of said fiber at the wavelength of 1310 nm is 8.5-9.3 $\mu$m; a zero dispersion wavelength thereof is 1302-1322 nm; and a dispersion slope thereof at the zero dispersion wavelength is less than or equal to 0.090 ps/nm$^2$·km.

6. The single mode fiber as claimed in claim 1 or claim 2, wherein an attenuation coefficient of said fiber at the wavelength of 1310 nm is less than or equal to 0.344 dB/km, an attenuation coefficient of the fiber at the wavelength of 1383 nm is less than or equal to 0.334 dB/km, an attenuation coefficient of the fiber at the wavelength of 1550 nm is less than or equal to 0.214 dB/km, an attenuation coefficient of the fiber at the wavelength of 1625 nm is less than or equal to 0.224 dB/km, and an attenuation coefficient of the fiber at the wavelength of 1675 nm is less than or equal to 0.284 dB/km.

7. The single mode fiber as claimed in claim 1 or claim 2, wherein a cutoff wavelength of said fiber is less than or equal to 1260 nm; at the wavelength of 1625 nm, an additional bending loss of said fiber after surrounding a 10 mm bending radius once is less than or equal to 0.2 dB; an additional bending loss of said fiber after surrounding a 7.5 mm bending radius once is less than or equal to 0.5 dB; and an additional bending loss of said fiber after surrounding a 5 mm bending radius once is less than or equal to 1.0 dB.

8. A method for producing a single mode fiber according to any of claims 1 to 7, the method comprising:

fixing a pure silica glass liner tube on a plasma enhanced chemical vapor deposition lathe for doping and depositing;
adding a fluorine-containing gas into the reactive gases of silicon tetrachloride and oxygen to introduce fluorine doping and adding germanium tetrachloride into the reactive gases of silicon tetrachloride and oxygen to introduce germanium doping;
ionizing the reactive gas in said liner tube with microwave into plasma and depositing said plasma in the form of glass on the inner wall of said liner tube;
altering the flow of doped gas in the mixed gas according to the doping requirements of optical waveguide structure and depositing a depressed cladding, an inner cladding, and a core in sequence;
melting the depositing tube into a solid mandrel with an electric heating furnace after depositing;
preparing a fiber preform using RIT process with synthetic silica glass as a casing tube, or by depositing an outer cladding surrounding the solid mandrel using OVD, VAD, or APVD outer depositing process by depositing an outer cladding surrounding said solid mandrel; and
drawing said fiber preform placed on in a fiber drawing tower and coating two layers of UV-cured acrylic resin polymer on the surface of said fiber

9. The method as claimed in claim 8, wherein the fluorine-containing gas is $C_2F_6$, $CF_4$, $SiF_4$, $C_4F_8$, $SF_6$, or a mixture thereof.

10. The method as claimed in claim 8 or claim 9, wherein in the process of depositing said depressed cladding, the furnace temperature is controlled at 1,080-1,120°C, the O/Si ratio is 3.0-3.5, and the chlorine content is less than 2,500 ppm.

11. The method as claimed in claim 8 or claim 9, wherein in the process of depositing said inner cladding and said core, the furnace temperature is controlled at 1,000-1,050°C, the O/Si ratio is 2.2-2.6, and the chlorine content is 3,500-4,200 ppm.

**Patentansprüche**

1. Einmodenfaser, umfassend:

einen Kern,
einen inneren Mantel,
einen abgesenkten Mantel, und
einen äußeren Mantel, der aus reinem Quarzglas besteht,
wobei
der Kern der Reihe nach vom inneren Mantel und dem abgesenkten Mantel umgeben ist;
**dadurch gekennzeichnet, dass**
der Kern Quarzglas umfasst, das mit Germanium und Fluor dotiert ist, mit einem Durchmesser von 8,0-8,8 μm, einer relativen Brechungsindexdifferenz $\Delta_1$ von 0,35-0,38 %, und der Beitrag von Fluor $\Delta_F$ -0,09 ± 0,02 % beträgt;
der innere Mantel Quarzglas umfasst, das mit Germanium und Fluor dotiert ist, mit einem Durchmesser von 18-21 μm und einer relativen Brechungsindexdifferenz $\Delta_2$ von 0 ± 0,02 %; und
der abgesenkte Mantel Quarzglas umfasst, das mit Fluor dotiert ist, mit einem Durchmesser von 26-36 μm, und einer relativen Brechungsindexdifferenz $\Delta_{32}$ an der äußeren Grenzfläche desselben zwischen -0,22 und -0,35 % und einer relativen Brechungsindexdifferenz $\Delta_{31}$ an der inneren Grenzfläche zwischen -0,20 und -0,35 %, und mit $\Delta_{32} \leq \Delta_{31}$ liegt.

2. Einmodenfaser nach Anspruch 1, wobei im inneren Mantel die Menge an dotiertem Fluor und dotiertem Germanium von der äußeren Grenzfläche zur inneren Grenzfläche allmählich ansteigt und dabei eine Gradientenänderung zeigt;

der Beitrag von Fluor $\Delta_F$ der äußeren Grenzfläche des inneren Mantels -0,10 $\pm$ 0,01 % beträgt; der Beitrag von Fluor $\Delta_F$ der inneren Grenzfläche des inneren Mantels -0,16$\pm$ 0,01 % beträgt.

3. Einmodenfaser nach Anspruch 1 oder 2, wobei die Materialzusammensetzung des Quarzglases, das mit Germanium und Fluor dotiert ist, $SiO_2$-$GeO_2$-F-Cl ist, und die Materialzusammensetzung des Quarzglases, das mit Fluor dotiert ist, $SiO_2$-F-Cl ist.

4. Einmodenfaser nach Anspruch 1 oder 2, wobei der äußere Mantel einen Durchmesser von 78-126 $\mu$m hat.

5. Einmodenfaser nach Anspruch 1 oder 2, wobei ein Modenfelddurchmesser der Faser bei der Wellenlänge von 1310 nm 8,5-9,3 $\mu$m beträgt; eine Null-Dispersions-Wellenlänge derselben 1302-1322 nm ist; und eine Dispersionsneigung derselben bei der Null-Dispersions-Wellenlänge kleiner oder gleich 0,090 ps/nm$^2$·km ist.

6. Einmodenfaser nach Anspruch 1 oder 2, wobei ein Dämpfungskoeffizient der Faser bei der Wellenlänge von 1310 nm kleiner oder gleich 0,344 dB/km ist, ein Dämpfungskoeffizient der Faser bei der Wellenlänge von 1383 nm kleiner oder gleich 0,334 dB/km ist, ein Dämpfungskoeffizient der Faser bei der Wellenlänge von 1550 nm kleiner oder gleich 0,214 dB/km ist, ein Dämpfungskoeffizient der Faser bei der Wellenlänge von 1625 nm kleiner oder gleich 0,224 dB/km ist und ein Dämpfungskoeffizient der Faser bei der Wellenlänge von 1675 nm kleiner oder gleich 0,284 dB/km ist.

7. Einmodenfaser nach Anspruch 1 oder 2, wobei eine Grenzwellenlänge der Faser kleiner oder gleich 1260 nm ist; bei der Wellenlänge von 1625 nm ein zusätzlicher Biegeverlust der Faser nach dem einmaligen Einschließen eines 10 mm-Biegeradius kleiner oder gleich 0,2 dB ist; ein zusätzlicher Biegeverlust der Faser nach dem einmaligen Einschließen eines 7,5 mm-Biegeradius kleiner oder gleich 0,5 dB ist; und ein zusätzlicher Biegeverlust der Faser nach dem einmaligen Einschließen eines 5 mm-Biegeradius kleiner oder gleich 1,0 dB ist.

8. Verfahren zum Herstellen einer Einmodenfaser nach einem der Ansprüche 1 bis 7, wobei das Verfahren Folgendes umfasst:

Fixieren eines Mantelröhrchens aus reinem Quarzglas auf einer plasmaverstärkten chemischen Dampfabscheidungsdrehmaschine zum Dotieren und Abscheiden;
Hinzufügen eines fluorhaltigen Gases zu den reaktiven Gasen Siliziumtetrachlorid und Sauerstoff, um die Fluordotierung einzuleiten, und Hinzufügen von Germaniumtetrachlorid zu den reaktiven Gasen von Siliziumtetrachlorid und Sauerstoff, um die Germaniumdotierung einzuleiten;
Ionisieren des reaktiven Gases in dem Mantelröhrchen mit Mikrowellen in Plasma und Abscheiden des Plasmas in Form von Glas auf der Innenwand des Mantelröhrchens;
Ändern des Stroms von dotiertem Gas im Mischgas gemäß den Dotierungsanforderungen der optischen Wellenleiterstruktur und der Reihe nach Abscheiden eines abgesenkten Mantels, eines inneren Mantels und eines Kerns;
Schmelzen des Abscheidungsröhrchens zu einer massiven Spindel mit einem elektrischen Heizofen nach dem Abscheiden;
Herstellen einer Faservorform unter Verwendung des RIT-Prozesses mit synthetischem Quarzglas als Überzugsrohr oder durch Abscheiden eines äußeren Mantels, der die massive Spindel umgibt, unter Verwendung des OVD-, VAD- oder APVD-Außenabscheidungsprozesses durch Abscheidung eines äußeren Mantels, der die massive Spindel umgibt; und
Ziehen der in einem Faserziehturm plazierten Faservorform und Auftragen von zwei Schichten aus UVgehärtetem Acrylharzpolymer auf die Oberfläche der Faser.

9. Verfahren nach Anspruch 8, wobei das fluorhaltige Gas $C_2F_6$, $CF_4$, $SiF_4$, $C_4F_8$, $SF_6$ oder eine Mischung derselben ist.

10. Verfahren nach Anspruch 8 oder 9, wobei im Prozess des Abscheidens des abgesenkten Mantels die Ofentemperatur auf 1.080-1.120 °C geregelt wird, das O/Si-Verhältnis 3,0-3,5 beträgt und der Chlorgehalt weniger als 2.500 ppm beträgt.

11. Verfahren nach Anspruch 8 oder 9, wobei im Prozess des Abscheidens des inneren Mantels und des Kerns die Ofentemperatur auf 1.000-1.050 °C geregelt wird, das O/Si-Verhältnis 2,2-2,6 beträgt und der Chlorgehalt 3.500-4.200 ppm beträgt.

**Revendications**

1. Fibre monomode, comprenant :

un coeur,
une gaine intérieure,
une gaine déprimée, et
une gaine extérieure se composant de pur verre de silice,
dans laquelle
ledit coeur est entouré en séquence par ladite gaine intérieure et ladite gaine déprimée ;
**caractérisée en ce que**
ledit coeur comprend du verre de silice dopé avec du germanium et du fluor, avec un diamètre de 8,0-8,8 $\mu$m, une différence relative d'indice de réfraction $\Delta_1$ de 0,35-0,38%, et la contribution du fluor $\Delta_F$ étant de-0,09 $\pm$ 0,02% ;
ladite gaine intérieure comprenant du verre de silice dopé avec du germanium et du fluor, avec un diamètre de 18-21 $\mu$m et une différence relative d'indice de réfraction $\Delta_2$ de 0 $\pm$ 0,02% ; et
ladite gaine déprimée comprenant du verre de silice dopé avec du fluor, avec un diamètre de 26-36 $\mu$m, et une différence relative d'indice de réfraction $\Delta_{32}$ à l'interface extérieure de celle-ci étant comprise entre -0,22 et -0,35%, et une différence relative d'indice de réfraction $\Delta_{31}$ à l'interface intérieure de celle-ci étant comprise entre -0,20 et -0,35%, et $\Delta_{32} \leq \Delta_{31}$.

2. Fibre monomode telle que revendiquée par la revendication 1, dans laquelle ladite gaine intérieure la quantité de fluor de dopage et de germanium de dopage augmente progressivement depuis ladite interface extérieure vers ladite interface intérieure, présente un changement de gradient ; la contribution du fluor $\Delta_F$ de l'interface extérieure de ladite gaine intérieure étant de -0,10 $\pm$ 0,01% ; la contribution du fluor $\Delta_F$ de l'interface intérieure de ladite gaine intérieure étant de -0,16 $\pm$ 0,01%.

3. Fibre monomode telle que revendiquée par la revendication 1 ou 2, dans laquelle la composition du matériau de verre de silice dopé avec du germanium et du fluor est : $SiO_2$-$GeO_2$-F-Cl, et la composition du matériau de verre de silice dopé avec du fluor étant : $SiO_2$-F-Cl.

4. Fibre monomode telle que revendiquée par la revendication 1 ou 2, dans laquelle ladite gaine extérieure a un diamètre de 78-126 $\mu$m.

5. Fibre monomode telle que revendiquée par la revendication 1 ou 2, dans laquelle un diamètre de champ de mode de ladite fibre à la longueur d'onde de 1310 nm est de 8,5-9,3 $\mu$m ; une longueur d'onde de dispersion nulle de celle-ci étant de 1302-1322 nm ; et une pente de dispersion de celle-ci à la longueur d'onde de dispersion nulle étant inférieure ou égale à 0,090 ps/nm$^2$·km.

6. Fibre monomode telle que revendiquée par la revendication 1 ou 2, dans laquelle un coefficient d'atténuation de ladite fibre à la longueur d'onde de 1310 nm est inférieur ou égal à 0,344 dB/km, un coefficient d'atténuation de la fibre à la longueur d'onde de 1383 nm étant inférieur ou égal à 0,334 dB/km, un coefficient d'atténuation de la fibre à la longueur d'onde de 1550 nm étant inférieur ou égal à 0,214 dB/km, un coefficient d'atténuation de la fibre à la longueur d'onde de 1625 nm étant inférieur ou égal à 0,224 dB/km, et un coefficient d'atténuation de la fibre à la longueur d'onde de 1675 nm étant inférieur ou égal à 0,284 dB/km.

7. Fibre monomode telle que revendiquée par la revendication 1 ou 2, dans laquelle une longueur d'onde de coupure de ladite fibre est inférieure ou égale à 1260 nm ; à la longueur d'onde de 1625 nm, une perte liée à la courbure additionnelle de ladite fibre après avoir enveloppé une fois un rayon de courbure de 10 mm étant inférieure ou égale à 0,2 dB ; une perte liée à la courbure additionnelle de ladite fibre après avoir enveloppé une fois un rayon de courbure de 7,5 mm étant inférieure ou égale à 0,5 dB ; et une perte liée à la courbure additionnelle de ladite fibre après avoir enveloppé une fois un rayon de courbure de 5 mm étant inférieure ou égale à 1,0 Db.

8. Procédé pour produire une fibre monomode selon l'une quelconque des revendications 1 à 7, le procédé comprenant :

la fixation d'un tube de chemisage en pur verre de silice sur un tour de dépôt chimique en phase vapeur amélioré par plasma pour le dopage et le dépôt ;
l'ajout d'un gaz contenant du fluor dans les gaz réactifs de tétrachlorure de silicium et d'oxygène pour engager le dopage au fluor, et l'ajout de tétrachlorure de germanium dans les gaz réactifs de tétrachlorure de silicium et d'oxygène pour engager un dopage au germanium ;

l'ionisation du gaz réactif dans ledit tube de chemisage avec des micro-ondes pour donner du plasma et déposer ledit plasma sous la forme de verre sur la paroi intérieure dudit tube de chemisage ;

la modification du flux de verre dopé dans le gaz mélangé en fonction des exigences de dopage d'une structure de guide d'ondes optique et le dépôt d'une gaine déprimée, d'une gaine intérieure et d'un coeur, en séquence ;

la fonte du tube de dépôt en un mandrin solide avec un four de chauffage électrique après le dépôt ;

la préparation d'un préforme de fibre en utilisant un processus RIT avec du verre de silice synthétique en tant que tube de revêtement, ou en déposant une gaine extérieure entourant le mandrin solide en utilisant un processus de dépôt extérieur OVD, VAD ou APVD en déposant une gaine extérieure enveloppant ledit mandrin solide ; et

l'étirage de ladite préforme de fibre placée sur une tour d'étirage de fibre et le revêtement de deux couches de polymère résineux acrylique traitées aux UV sur la surface de ladite fibre.

9. Procédé tel que revendiqué par la revendication 8, dans lequel le gaz contenant du fluor est du $C_2F_6$, du $CF_4$, du $SiF_4$, du $C_4F_8$, du $SF_6$ ou un mélange de ceux-ci.

10. Procédé tel que revendiqué par la revendication 8 ou 9, dans lequel, lors du processus de dépôt de ladite gaine déprimée, la température du four est régulée à 1.080-1.120°C, le rapport O/Si étant de 3,0-3,5 et la teneur en chlore étant inférieure à 2,500 ppm.

11. Procédé tel que revendiqué par la revendication 8 ou la revendication 9, dans lequel, lors du processus de dépôt de ladite gaine intérieure et dudit coeur, la température du four est régulée à 1.000-1.050°C, le rapport O/Si étant de 2,2-2,6 et la teneur en chlore étant de 3.500-4.200 ppm.

FIG. 1 (Prior art)

FIG. 2 (Prior art)

**FIG. 3 (Prior art)**

Tensile stress caused by bending (Gpa)

**Bending radius (mm)**

**FIG. 4 (Prior art)**

**FIG. 5**

**FIG. 6**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 20070077016 A1
- CN 1971321 A
- CN 1942793 A
- US 5032001 A
- US 7043125 B2
- CN 1766680 A
- US 4852968 A
- US 6535679 B2
- CN 1982928 A
- EP 1806599 A1

### Non-patent literature cited in the description

- **DAVID Z.HEN.** Testing MPI Threshold in Bend Insensitive Fiber Using Coherent Peak-To-Peak Power Method. *OFC/NFOEC,* 2009
- **QINGRONG HAN et al.** Material Composition and Structure Design in PCVD Silica-based Single-Mode fiber. *Proc. Of SPIE,* vol. 6352, 635236-1, 8